# EUROPEAN PATENT APPLICATION

(11) **EP 2 596 874 A1**
(43) Date of publication of application: **29.05.2013**
(21) Application number: 11809551.2
(22) Date of filing: 01.07.2011
(51) Int. Cl.: B05D 7/24, B05D 3/02, B05D 3/06

(54) **METHOD FOR PRODUCING GAS BARRIER FILM**

(30) Priority: 22.07.2010 JP 2010164712
(71) Applicant: Konica Minolta Holdings, Inc., Tokyo 100-0005 (JP)
(72) Inventor: AKAGI Kiyoshi, Hino-shi Tokyo 191-8511 (JP)
(74) Representative: Henkel, Breuer & Partner
(86) International application number: PCT/JP2011/065156
(87) International publication number: WO 2012/011377

(57) **Abstract**

Disclosed is a method for producing a gas barrier film, wherein a coating liquid containing a polysilazane is applied and a VUV treatment is carried out, and which prevents incorporation of a modification-inhibiting adsorbate into the coating film, thereby further improving the gas barrier performance. In the method for producing a gas barrier film, a coating film is formed by applying a coating liquid that contains a polysilazane over the surface of a film, and after having the resulting film pass through a drying zone, the film is irradiated with vacuum ultraviolet light from the coating film side and modified. The method for producing a gas barrier film is characterized in that an inert gas is supplied into the drying zone so that the oxygen concentration therein is 10% or less.

## Description

### TECHNICAL FIELD

The present invention relates mainly to packages for an electronic device and so forth, or to a method of manufacturing a gas barrier film used for a display material including plastic substrates for an organic electroluminescence (EL) element, a solar cell, liquid crystal and so forth.

### BACKGROUND

A gas barrier film, in which a plurality of layers including metal oxide thin films such as an aluminum oxide thin film, a magnesium oxide thin film, a silicon oxide thin film and so forth are laminated and formed on the surface of a plastic substrate or film has been widely utilized conventionally for packaging application to pack goods necessary for shielding various gases such as water vapor, oxygen and so forth, and to avoid alteration in quality of food, industrial goods, pharmaceutical products and so forth. Further, in those other than packaging application, it has been used as a solar cell element, an organic electroluminescence (EL) element, a liquid crystal display element or the like.

As methods each of forming such a gas barrier film, known are a chemical vapor deposition method (a plasma CVD method) by which a film is formed on a substrate during oxidation with oxygen plasma at reduced pressure, employing an organic silicon compound typified by TEOS (tetraethoxy silane), and a sputtering method by which metal silicon is evaporated employing a semiconductor laser to deposit it on a substrate in the presence of oxygen. These methods have been desirably used for formation of metal oxide thin films such as a SiO₂ thin film and so forth, since a thin film having an accurate composition can be formed on a substrate, but poor productivity has largely resulted since time is consumed on the ground of reduced pressure and opening to the atmosphere, difficult continuous production, and large-size equipment to be used because of deposition at reduced pressure.

In order to solve these problems, utilized are a method by which a silicon-containing compound is coated to form a silicon oxide thin film via modification of the coating film, and the same CVD method as previously mentioned in which plasma is generated under atmospheric pressure to form a film, and a gas barrier film has also been applied thereto, and studied.

As a silicon oxide film which can be generally prepared by a solution process, known is a preparation technique called a sol-gel method employing an alkoxide compound as raw material. In this sol-gel method, heating to high temperature is generally necessary, and large contraction in volume further occurs in the process of dehydration-condensation reaction, resulting in generation of a large number of defects in the film. In order to avoid the foregoing, a method by which organic substances and so forth directly having no involvement in formation of oxide is mixed in a raw material solution is known, but when these organic substances remain in the film, there are growing concerns about decline of a barrier property of the entire film.

For this reason, it was difficult to use an oxide film to be prepared by a sol-gel method as a protective film for a flexible electronic device as it is.

As another method, it is proposed that a silicon oxide film is formed using a silazane compound having a silazane structure (Si-N) as a basic structure in raw material. Since reaction in this case is not dehydration-condensation reaction but direct substitution reaction from nitrogen to oxygen, mass yield before and after the reaction is a large value such as 80% to 100%, whereby it is known that a dense film having reduced defects in the film, caused by contraction in volume. However, since temperature higher than 450 °C should be applied for preparation of a silicon oxide film via substitution reaction of the silazane compound, it is impossible that a flexible substrate made of plastic or the like is suitably applicable.

As a means to solve such a problem, it is described in Patent Document 1 that heating temperature is lowered, and a heating duration thereof can be shortened during formation of a silica coating film when a coating film ofpolysilazane is exposed to UV radiation.

Further, in Patent Document 2, a technique by which temperature applied in a ceramics-formation treatment is lowered by using a catalyst is disclosed in order to obtain a good gas barrier film suitable for a plastic film via lowering of temperature applied in the ceramics-formation treatment

However, the above-described Patent Document 2 has a feature in which a coating film containing polysilazane is formed on the surface of a substrate, and a UV radiation exposure step in which a high pressure mercury lamp or the like is used is involved employing a catalyst to lower temperature applied in the foregoing ceramics-formation treatment in a method of forming a ceramics film substantially formed from SiO₂ after the foregoing coating film is subjected to the ceramics-formation treatment, but a level where modification (ceramics-formation) efficiency is sufficiently improved has not yet been achieved.

In response to the above-described problem, proposed is a method by which oxidation reaction with active oxygen or ozone can be accelerated while directly cutting via action with only photon called a photon process for atomic binding, employing light energy having a wavelength of 100 -200 nm called vacuum UV light (hereinafter, referred to also as "VUV radiation") larger than interatomic binding force inside the silazane compound to form a silicon oxide film at considerably low temperature. Disclosed is a technique in which a polysilazane film is formed by a wet process, and the polysilazane film is modified as a silicone oxide thin film via exposure thereof exposed to UVU light having a wavelength of 150 - 200 nm to form a barrier layer (refer to Patent Document 3).

However, since substances present between a vacuum UV radiation light source and a silazane film such as oxygen gas in the space present in the middle of the optical path, dust of organic substances attached onto the surface of the polysilazane film, adsorbed moisture and oxygen molecules, or a coating solvent remaining in and on the polysilazane film absorb vacuum UV radiation, energy necessary to form a silicon oxide film is to be taken out via absorption of the original silazane compound. In such a way, impurities present on the surface after coating and drying processes suppress modification at high efficiency, and as a result, an excellent gas barrier property has not been effectively achieved.

### PRIOR ART DOCUMENT

### PATENT DOCUMENT

Patent Document 1 : Japanese Patent O.P.I. (Open to Public Inspection) Publication No. 5-105486.
Patent Document 2 : Japanese Patent O.P.I. Publication No. 10-279362.
Patent Document 3 : Published Japanese translation of PCT international Publication No. 2009-503157

### DISCLOSURE OF THE INVENTION

### PROBLEMS TO BE SOLVED BY THE INVENTION

When a coating film is prepared by a coating process employing a coating solution containing polysilazane, and the coating film is exposed to vacuum UV radiation, followed by a modification treatment to form a ceramics film substantially made from SiO₂, a barrier film can be obtained, but the barrier film obtained in this way exhibited fluctuation in performance.

It appears that this fluctuation is caused by fluctuation of a modification efficiency. In order to reduce this cause, there is a method of reducing modification-suppressing substances adsorbed on the coating film after drying. However, for this reason, a surface treatment was conducted as a step conducted before exposure thereof to vacuum UV radiation and after drying, or during exposure to UV radiation, conducted was a step of spraying the gas as gas by which vacuum UV radiation is not absorbed, as a main component, accompanied with exposure to vacuum UV radiation.

However, it was found out that since modification-suppressing adsorbed substances were taken in a coating film during coating and drying of a coating solution, the modification-suppressing adsorbed substances could not be sufficiently reduced even though conducting the above-described treatment after drying, resulting in a limited effect of the resulting gas barrier property.

Thus, it is an object of the present invention to provide a method by which it is inhibited that modification-suppressing adsorbed substances are taken in the coating film to further improve gas barrier performance in a method of manufacturing a gas barrier film in which a coating solution containing polysilazane is coated, followed by application of a VUV radiation treatment.

### MEANS TO SOLVE THE PROBLEMS

The above-described problems can be accomplished by the following structures.

(Structure 1) A method of manufacturing a gas barrier film, comprising the steps of coating a coating solution containing polysilazane on a surface of a film to form a coating film, followed by making the resulting film to pass through a drying zone, and exposing the surface of the coating film to vacuum UV radiation to conduct a modification treatment, wherein oxygen concentration in the drying zone, achieved by supplying inert gas into the drying zone is 10% or less.

(Structure 2) The method of Structure 1, wherein the oxygen concentration is 5% or less.

(Structure 3) The method of Structure 1 or 2, wherein the oxygen concentration during exposure to the vacuum UV radiation is 0.05 - 1%.

(Structure 4) The method of any one of Structures 1 - 3, wherein the vacuum UV radiation is emitted with a Xenon excimer lamp.

### EFFECT OF THE INVENTION

In the present invention, a gas barrier film exhibiting excellent gas barrier performance was able to be provided when a coating solution containing polysilazane was coated, followed by drying a coating film in atmosphere of oxygen concentration of 10% or less to prevent the modification-suppressing adsorbed substances from penetrating into the coating film.

### BRIEF DESCRIPTION OF THE DRAWING

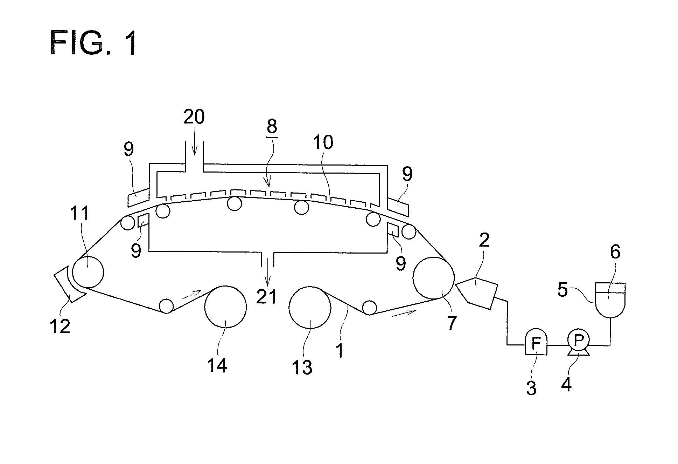

Fig. 1 is a schematic diagram showing an example of an apparatus with which a gas barrier film is prepared by a slot-die coating method

### DESCRIPTION OF THE PREFERRED EMBODIMENTS

### (Gas barrier film)

A gas barrier film of the present invention will be described.

A gas barrier film possesses a barrier film exhibiting barrier performance when at least one layer as a coating film containing polysilazane is formed on a resin film substrate, for example, at least one surface of polyethylene terephthalate (PET), and the resulting system is subjected to a modification treatment, and as to the barrier film, the coating film is subjected to the modification treatment via a drying zone and vacuum UV radiation after coating a polysilazane-containing layer.

In addition, the gas barrier layer may be composed of a single layer, or may be one in which the same plural layers as the foregoing single layer are laminated, and a gas barrier property is possible to be further improved by laminating the plural layers. In this specification, no lamination structure is exemplified, but the lamination structure is preferably usable in order to realize a higher gas barrier property by utilizing the effect of the present invention.

### (Coating method and drying method of polysilazane-containing layer)

The coating method of the present invention is not specifically limited as long as it is a method by which a coating solution containing polysilazane is coated on the surface of a film to form a wet film (coating film).

Specific examples of the coating method include a spin coating method, a roll coating method, a flow coating method, an ink-jet method, a spray coating method, a printing method, a dip coating method, a cast film-forming method, a bar coating method, a gravure printing method, a slot-die coating method, a slide coating method, a curtain coating method and so forth. The coating film is designed to preferably have a dry film thickness of 1 nm to about 100 µm; more preferably have a dry film thickness of 10 nm to about 10 µm; and most preferably have a dry film thickness of 10 nm to about 1 µm.

A method by which a wet film having been formed in this way is dried to obtain a dry coating film is not specifically limited as long as a drying zone is formed at an oxygen concentration of 10% or less achieved by supplying inert gas into the drying zone.

Usable examples of the inert gas include nitrogen gas, helium gas, neon gas, and so forth, but nitrogen gas is preferable.

The drying zone is desired to have an oxygen concentration of 10% or less, but preferably has an oxygen concentration of 5% or less. The reason of this is that when oxygen concentration in the drying zone exceeds 10%, oxygen is excessively taken in the dry coating film, and it appears that oxygen having been taken in tends to become an absorbent of vacuum UV radiation in the subsequent modification treatment, and as a result, is likely to disturb the subsequent modification treatment for the above-described coating film. When the drying zone has an oxygen concentration of 5% or less, it is preferable to hardly disturb the above-described modification treatment

The drying zone evaporates a solvent, and performs drying by supplying and evacuating inert gas, but the inert gas is preferably heated at the same time, and further, a method by which a substrate is heated may be used.

Details of the polysilazane compound will be described later.

### (Modification treatment for coating film)

### {Vacuum UV radiation (VUV light) treatment}

A modified film is formed for a gas barrier film of the present invention by a method by which a solution containing polysilazane is coated on a substrate, followed by drying, and a coating film containing polysilazane is subsequently exposed to vacuum UV radiation. Through exposure to the vacuum UV radiation (VUV light), molecular bonds of polysilazane are broken, and ceramics^formation of the coating film is accelerated (modification treatment) for the reason that oxygen present in minute amounts in the film or in an atmosphere is also possible to be efficiently converted into ozone or active oxygen, whereby the resulting ceramics film also becomes even dense. The exposure to VUV radiation is effective even though performing at any time after forming a coating film.

As vacuum UV radiation of the present invention, specifically used is vacuum UV radiation (VUV light) having a wavelength of 100 - 200 nm. As to vacuum UV radiation, exposure intensity and exposure time are designed to be set in the range where a substrate supporting a coating film to be exposed to the vacuum UV radiation is not damaged. When the case where a plastic film is used as a substrate is taken as an example, distance between the substrate and a lamp is designed to be set in such a way that the substrate surface has a strength of 10 - 300 mW/cm², and an exposure time of 0.1 seconds to 10 minutes but of preferably 0.5 seconds to 3 minutes can be applicable. As a vacuum UV radiation exposure apparatus, usable is a commercially available lamp (manufactured by USHIO INC., for example).

VUV radiation exposure is possible to be applied to not only a batch process but also a continuous process, and these can be appropriately selected depending on shape of the substrate to be coated. For example, in the case of the batch process, a substrate having a polysilazane coating film provided on the surface of the substrate (silicon wafer, for example) can be subjected to a processing employing vacuum UV radiation calcination furnace equipped with a UV radiation generation source. A vacuum UV radiation generation source. A vacuum UV radiation furnace itself is conventionally known, and one manufactured by USHIO INC., for example, is usable. In cases where a substrate having a polysilazane coating film provided on the surface of the substrate is in the form of a long-length film, exposure thereof to vacuum UV radiation is continuously conducted in a drying zone equipped with the above-described vacuum UV radiation generation source while transporting the resulting one described above to conduct a modification treatment.

Since the vacuum UV radiation has larger interatomic bonding force than that of each of most of substances, the interatomic bond is possible to be directly broken via action of only photon called a photon process. A modification treatment is possible to be efficiently conducted at low temperature by using this action with no application of hydrolysis.

As a vacuum UV radiation source used for this, preferably usable is a rare gas excimer lamp. Rare gas atoms such as Xe, Kr, Ar, Ne and so forth called inert gases, since they do not produce molecules via chemical bonding. However, a rare gas atom in which energy is acquired via discharge or the like (excited atom) can produce molecules via bonding of other atoms. When the rare gas is Xenon, the following are made.

e + Xe → e + Xe*

Xe* + Xe + Xe → Xe₂* + Xe

When Xe₂* as an excited excimer molecule is transited to the ground state, excimer light having a wavelength of 172 nm is emitted. It is a feature that high efficiency is obtained since radiation concentrates on one wavelength, and those excluding necessary light are not mostly emitted.

Further, since extra light is not emitted, temperature of an object can be maintained at a low temperature.

Furthermore, since time is not consumed for starting restarting, instant lighting or flashing is possible.

In order to obtain excimer light emission, known is a method employing dielectric barrier discharge. The dielectric barrier discharge is discharge called very fine micro discharge similar to thunder generated in a gas space by applying voltage having a high frequency of several tens of kHz to electrodes, when the gas space is provided between both the electrodes via a dielectric (transparent quartz in the case of an excimer lamp), and the micro discharge disappears since charge remains on the surface of the dielectric when a streamer of the micro discharge reaches a tube wall (dielectric). The micro discharge is expanded to the entire tube wall, and is discharge in which generation disappearance is repeated. For this reason, flicker of light observed by the naked eye is produced. Further, deterioration of the tube wall is possible to be accelerated since a streamer at very high temperature locally reaches the tube wall directly.

A method of effectively acquiring excimer light emission is also possible to be conducted via electrodeless electric field discharge other than dielectric barrier discharge.

It is electrodeless electric field discharge conducted via capacitive bonding called RF discharge as another name. Lamps, electrodes and their installation may be basically in the same situation as in the dielectric barrier discharge, but high frequency applied between both electrodes is turned on at several MHz. A long-life lamp exhibiting no flicker can be obtained since electrodeless electric field discharge produces uniform discharge spacially and temporally in this way.

In the case of the dielectric barrier discharge, since micro discharge is generated between electrodes, an electrode on the outer side has to be one covering the entire external surface to conduct discharge in the entire discharge space, and transmitting light to derive light to the outside. For this reason, an electrode in which thin metal wires are reticulated is used. Since a wire being as thin as possible is used in such a way that this electrode blocks light, it is easily damaged in oxygen atmosphere by ozone or the like produced via vacuum UV radiation.

In order to protect this, the inside of an exposure apparatus, that is; circumference of a lamp is filled with inert gas such as nitrogen or the like, a synthetic quartz window is desired to be provided to take light out. Not only the synthetic quartz window is a consumable item, but also loss of light is generated.

Since a dual cylindrical lamp has an outer diameter of roughly 25 mm, difference of the distance up to the surface to be exposed to light can not be neglected at the portion immediately below the lamp axis and on the side surface of the lamp, whereby large difference in illuminance occurs. Accordingly, even though the lamp is attached thereto, no uniform illuminance distribution is obtained. When an exposure apparatus equipped with a synthetic quartz window is used, this can make the distance in oxygen atmosphere to be uniform, whereby a uniform illuminance distribution is obtained.

In cases where an electrodeless electric field discharge is used, no external electrode in which thin metal wires are reticulated needs to be used. Glow discharge is expanded to the entire discharge space by only providing an external electrode on a part of the outer surface of a lamp. An electrode generally serving as a light reflection plate formed from aluminum blocks is used as an external electrode on the back surface of the lamp. However, synthetic quartz should be used in order to realize a uniform illuminance distribution, since the outer diameter of the lamp is large similarly to the case of dielectric barrier discharge.

It is the most distinctive feature that a narrow tube excimer lamp has a simple structure. Both ends of a quartz tube are closed, and gas to conduct excimer emission is only introduced into the inside of the tube.

The narrow tube lamp has a tube outer diameter of approximately 6 mm to 12 mm, but when the tube outer diameter is too large, high voltage needs be applied thereto at the beginning of operation.

As an embodiment of discharge, usable is any of dielectric barrier discharge and electroleless electric field discharge. As to shape of an electrode, the surface brought into contact with a lamp may be the plane, but in the case of shape designed for the curved surface of a lamp, the lamp can be firmly secured, and the electrode is closely attached onto the lamp, whereby discharge becomes more stable. Further, when the curved surface is replaced by the mirror surface employing aluminum, the mirror surface becomes a reflection plate.

Since a Xe excimer lamp emits UV radiation having a short wavelength of 172 nm as a single wavelength, it exhibits excellent emission efficiency. Since this light has a large absorption coefficient of oxygen, radical oxygen atomic species and ozone can be generated at high concentration, employing a small amount of oxygen. Further, it is known that light energy having a short wavelength of 172 nm to dissociate bonding of an organic substance exhibits high ability. It can be realized that a polysilazane layer is modified in a short duration via these by these active oxygen and ozone together with high energy possessed by UV radiation. Accordingly, reduction of processing time along with high throughput, reduction of installation area, and exposing an organic substance and a plastic substrate or the like easily to be damaged via heat, to light become possible in comparison with a low pressure mercury lamp having a wavelength of 185 nm or 254 nm, and plasma cleaning.

Since an excimer lamp has high light generation efficiency, it is possible to be turned on via application of low electric power. Further, light having a long wavelength as a cause of temperature rise produced by light is not emitted, and since exposure to energy is made at a single wavelength in the UV radiation region, it is a feature of the excimer lamp that rise of temperature of the surface of an object to be exposed is suppressed.

### (Exposure intensity of vacuum UV radiation)

### (High exposure intensity treatment and maximum exposure intensity)

When exposure intensity is high, probability in which photons and chemical bonds inside polysilazane collide with each other is increased, whereby the duration of modification reaction can be shortened. Further, since the number of photons penetrating into the inside is also increased, thickness of the modified film is also possible to be increased, and the film quality is possible to be improved (highly densified). However, when the exposure time is too long, degradation of flatness is produced, and the material other than a barrier film tends to be damaged. In general, the accelerating pace of reaction is taken into account by an integral amount of light expressed as the product of the exposure intensity and the exposure time, but in the case of a material like silicon oxide capable of having various morphology structures even though the composition is identical to each other, an absolute value of exposure intensity tends to be significant.

Accordingly, in the VUV exposure step according to the present invention, a modification treatment at a maximum exposure intensity of 100 - 200 mW/cm² is preferably conducted at least once. In the case of not more than this exposure intensity, the modification efficiency rapidly drops, whereby longer time is consumed for the treatment In the case of not less than this exposure intensity, not only rise of gas barrier performance slows down, but also a substrate is damaged, and a lamp, a lamp unit and other members are also largely damaged, resulting in accelerated deterioration of the lamp itself

### (Exposure time of VUV radiation)

The exposure time is arbitrarily adjustable, but the exposure time in a high illuminance process is preferably 0.1 seconds to 3 minutes, and more preferably 0.5 seconds to one minute in view of reduction of fluctuation in gas barrier performance in consideration of damage of a substrate and appearance of film defects.

### (Oxygen concentration during exposure to VUV radiation)

The oxygen concentration during exposure to VUV radiation in the present invention is preferably 500 *-* 10000 ppm (0.05 -1 %), and more preferably 1000 - 5000 ppm. When the oxygen concentration is lower than 500 ppm, oxygen thereof tends to be insufficient in quantity in order to conduct a modification treatment via exposure to VUV radiation. When the concentration is higher than 10000 ppm, oxygen thereof is excessive in quantity, whereby no gas barrier property tends to be obtained for the reason that VUV radiation during exposure to the VUV radiation does not possibly reach the coating film, and a gas barrier film having an excessive amount of oxygen is formed. Further, in the case of an oxygen concentration lower than the foregoing range, time to be replaced by the atmosphere becomes longer, and at the same time, the oxygen concentration can not be adjusted unless flowing a large amount of gas flow since an amount of air (including oxygen) rolled up to the inside of a VUV radiation exposure chamber is increased via conveyance of a web when continuous production like roll-to-roll production is performed.

According to studies done by the inventor, it was confirmed that since oxygen and a slight amount of water content were penetrated into a polysilazane-containing coating film during coating, and oxygen and water were further adsorbed in a support other than the coating film, there was a sufficient oxygen source to supply oxygen used for modification reaction even though oxygen did not dare to be introduced into an exposure chamber. In the case of rather exposure thereof to VUV radiation in an atmosphere containing a large amount of oxygen (at a level of a few hundredth of a percent), the gas barrier film after modification possesses a structure having an excessive amount of oxygen, resulting in degradation of gas barrier performance. Further, as described before, VUV radiation having a wavelength of 172 nm is absorbed by oxygen, and an amount of light having a wavelength of 172 nm, which reaches the surface of a film, is to be reduced, whereby optical treatment efficiency is lowered. That is, a modification treatment is preferably conducted at the condition where the oxygen concentration is at the lowest possible level, as well as at the condition where VUV radiation effectively reaches the coating film, during exposure thereof to VUV radiation.

As gas other than oxygen during exposure to VUV radiation, it is preferable to use dry inert gas, and dry nitrogen gas is significantly preferable in view of cost The oxygen concentration is possible to be adjusted by varying a flow rate after measuring the flow of oxygen gas introduced into an exposure chamber, and the flow of inert gas.

### (Polysilazane film)

A polysilazane film of the present invention is formed by coating a coating solution containing a polysilazane compound for at least one layer provided on a substrate.

"Polysilazane" used in the present invention means a polymer having a silicon-nitrogen bond, which is a ceramic precursor polymer such as an intermediate solid solution SiOₓN_{y} of SiO₂, Si₃N₄ or both of them formed from Si-N, Si-H, N-H or the like.

In order to coat it in such a way that a film substrate is not deteriorated, it is preferable that polysilazane having a unit represented by the following Formula (1) as described in Japanese Patent O.P.I. Publication No. 8-112879 is ceramic-formed at considerably low temperature to be modified into silica. 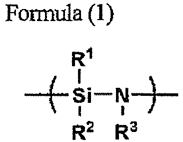 wherein each of R¹, R² and R³ independently represents a hydrogen atom, an alkyl group, an alkenyl group, a cycloalkyl group, an aryl group, an alkenyl group, an alkylamino group, an alkoxy group or the like.

In the present invention, perhydropolysilazane in which all of R¹, R² and R³ are hydrogen atoms is preferable in view of a film-dense property of the resulting gas barrier layer.

Organopolysilazane in which hydrogen portions bonded to Si thereof has the advantage that adhesion to a subbing layer is improved via possession of an alkyl group such as a methyl group or the like in the organopolysilazane; toughness can be added to a ceramic film produced by hard and brittle polysilazane; and generation of cracks is suppressed even though designing thickness of a thicker film. These perhydrosilazane and organopolysilazane may be approximately selected depending on the application, and may be used as a mixture of them.

Perhydrosilazane preferably has a structure in which a straight chain structure and a cyclic structure mainly having six and eight-membered rings are present. The molecular weight is a number average molecular weight of approximately 600 - 2000 in terms of polystyrene conversion, and the foregoing material is composed of liquid or solid though depending on molecular weight. This is commercially available in the state of a solution dissolved in an organic solvent, and the commercially available product is usable as it is, as a polysilazane-containing coating solution.

Examples of polysilazane compounds each ceramic-formed at low temperature include silicon alkoxide-addition polysilazane obtained via reaction of silicon alkoxide with the above-described polysilazane (disclosed in Japanese Patent O.P.I. Publication No. 5-238827); glycidol-addition polysilazane obtained via reaction of glycidol (disclosed in Japanese Patent O.P.I. Publication No. 6-122852); alcohol-addition polysilazane obtained via reaction of alcohol (disclosed in Japanese Patent O.P.I. Publication No. 6-240208); metal carboxylate-addition polysilazane obtained via reaction of metal carboxylate (disclosed in Japanese Patent O.P.I. Publication No. 6-299118); acetylacetonate complex-addition polysilazane obtained via reaction of acetylacetonate complex containing metal (disclosed in Japanese Patent O.P.I. Publication No. 6-306329); metal particle-addition polysilazane obtained via addition of metal particles (disclosed in Japanese Patent O.P.I. Publication No. 7-196986); and so forth.

Those containing alcohol or water to be easily reacted with polysilazane are not preferably used as an organic solvent to prepare liquid containing polysilazane. Specifically usable examples thereof include hydrocarbon solvents such as aliphatic hydrocarbon, cyclic hydrocarbon, aromatic hydrocarbon and so forth; halogenated hydrocarbon solvents; and ethers such as aliphatic ether, cyclic ether and so forth. Specific examples of hydrocarbons include pentane, hexane, cyclohexane, toluene, xylene, solvesso, turpentine, and so forth; specific examples of halogenated hydrocarbons include methylene, chloride, trichloroethane and so forth; and specific examples of ethers include dibutylether, dioxane, tetrahydrofuran and so forth. These solvents are selected depending on the purposes of solubility of polysilazane, vaporization speed of a solvent and so forth, and a plurality of solvents may be mixed.

Polysilazane in a polysilazane-containing coating solution approximately has a content of 0.2 - 35% by weight, depending on targeted thickness of a silica layer and pot life of a coating solution.

Organic polysilazane may be a derivative in which hydrogen portions each bonded to Si thereof partially are substituted with alkyl groups. Since adhesion to a subbing layer is improved via possession of a methyl group having the least molecular weight, and toughness can be added to a hard and brittle silica film, generation of cracks is suppressed even though designing thickness of a thicker film.

In order to accelerate modification to a silicon oxide compound, added can be an amine or metal catalyst. Specific examples thereof include AQUAMICA NAX 120-20, AQUAMICA NH 110, AQUAMICA NH 310, AQUAMICA NH 320, AQUAMICA NL 110A, AQUAMICA NL 120A, AQUAMICA NL 150A, AQUAMICA NP 110, AQUAMICA NP 140, AQUAMICA SP 140 and so forth, which are produced by AZ Electronic Materials Co., Ltd.

### (Concentration of catalyst)

Since hydrolysis - dehydration-condensation is accelerated via addition of a catalyst, the addition amount largely changes a production speed of a Si-OH group. That is, when the catalyst is excessively added therein, the excessive Si-OH group results in formation of a large film via aging change. Further, as described before, when sufficient energy is given via exposure to vacuum UV radiation in order to break molecular bonds, an amine based catalyst specifically tends to be degraded and evaporated. When a catalyst is degraded and evaporated, impurities and pores tend to be contained inside a modified film, resulting in degradation of barrier performance thereof.

In the present invention, in order to avoid excessive formation of silanol caused by a catalyst, decline of film density, and increase of film defects, it is preferable to adjust an addition amount of the catalyst with respect to polysilazane to 2% by weight or less. Further, no addition of a catalyst is more preferable in view of inhibition of Si-OH formation.

### (Support)

A support for a gas barrier film in the present invention is not specifically limited as long as it is formed of an organic material capable of supporting the gas barrier film exhibiting the after-mentioned gas barrier property.

Examples thereof include resin films each made of acrylic acid ester, methacrylic acid ester, polyethylene terephthalate (PET), polybutylene terephthalate, polyethylene naphthalate (PEN), polycarbonate (PC), polyacrylate, polyvinyl chloride (PVC), polyethylene (PE), polypropylene (PP), polystyrene (PS), nylon (Ny), aromatic polyamide, polyetherether ketone, polysulfone, polyethersulfone, polyimide, polyether imide or the like; heat resistant transparent films each having silsesquioxane as a base skeleton, which has an organic inorganic hybrid structure (product name Sila-DEC, produced by Chisso Corporation); resin films each in which at least two layers each made of the foregoing resin are laminated; and so forth.

Polyethylene terephthalate (PET), polybutylene terephthalate, polyethylene naphthalate (PEN), polycarbonate (PC) and so forth are preferably usable in view of coat and commercial availability, and heat resistant transparent films each having silsesquioxane as a base skeleton, which has an organic inorganic hybrid structure are preferably usable in view of optical transparency, heat resistance, adhesion to an inorganic layer, and adhesion to a gas barrier layer. The support preferably has a thickness of roughly 5 - 500 µm, and more preferably has a thickness of 25 - 250 µm.

Further, the support of the present invention is preferably transparent. A gas barrier film is possible to be made since the support is transparent, and a layer formed on the support is also transparent, whereby this enables a transparent substrate for an organic EL element or the like.

Further, the support made of each of resins described above may be an unstretched film, or may be a stretched film.

The support used in the present invention is possible to be prepared by a commonly known conventional method. For example, a resin as a material can be melted with an extruder, and rapidly cooled after the melted resin is extruded through an annular die or a T die to prepare an unstretched support which is substantially amorphous, and is not oriented.

An unstreached support is also oriented in the support running direction (vertical axis) or in the direction at right angle to the support running direction (horizontal axis) by a commonly known method such as a uniaxially stretching method, a tenter type individual biaxially stretching method, a tenter type simultaneous biaxially stretching method or a tubular type simultaneous biaxially stretching method to produce a stretched support. In this case, a stretching magnification is preferably 2 -10 times in each of the vertical axis direction and the horizontal axis direction, though the magnification can be selected appropriately to fit a resin as a support material. Further, in order to improve dimension stability of the substrate with respect to a stretched film, a relaxation treatment is preferably conducted after stretching.

The support of the present invention may also be subjected to a corona treatment before coating a film thereon. Further, an anchor coating agent layer may be formed on the surface on the side where a coating film provided on the substrate of the present invention is formed, in order to improve adhesion to the coating film.

### «Anchor coating agent layer»

The gas barrier film of the present invention may possess an anchor coating agent layer, and examples of anchor coating agents used for this anchor coating agent layer include a polyester resin, an isocyanate resin, a urethane resin, an acrylic resin, an ethylene vinyl alcohol resin, a vinyl-modified resin, an epoxy resin, a modified styrene resin, a modified silicon resin, alkyl titanate and so forth, and these may be used singly or in combination with at least two kinds thereof

Commonly known conventional additives can be added into each of these anchor coating agents. The above-described anchor coating agent can be coated on a support by a commonly known method such as a roll coating method, a gravure coating method, a knife coating method, a dip coating method, a spray coating method or the like, and a solvent, a diluent and so forth are removed therefrom via drying to conduct anchor coating. A coating amount of the above-described anchor coating agent is preferably about 0.1-5 g/m² under the dry condition.

### <<Flat and smooth layer>>

A gas barrier film of the present invention may possess a flat and smooth layer. The roughened surface of a transparent resin film support on which protrusions are present is planarized with the flat and smooth layer, or asperity and pinholes produced on a transparent inorganic compound layer, which are caused by protrusions present on a transparent resin film support are smoothed and planarized by the flat and smooth layer. Such a flat and smooth layer is formed by basically curing a photosensitive resin.

Examples of the photosensitive resin constituting the flat and smooth layer include a resin composition containing an acrylate compound possessing a radical reactive unsaturated compound, a resin composition containing a mercapto compound possessing an acrylate compound and a thiol group, a resin composite obtained by dissolving a polyfunctional acrylate monomer such as epoxy acrylate, urethane acrylate, polyester acrylate, polyether acrylate, polyethylene glycol acrylate, glycerol methacrylate or the like, and so forth. Further, any admixture of the above-described resin compositions is possible to be used, and the resin is not specifically limited as long as it is a photosensitive resin containing a reactive monomer having at least one photo-polymerizable unsaturated bond in the molecule.

A method of forming a flat and smooth layer is not specifically limited, but the flat and smooth layer is preferably formed by a wet coating method such as a spin coating method, a spray method, a blade coating method, a dip method or the like, or a dry coating method such as an evaporation method or the like.

As to formation of a flat and smooth layer, additives such as an antioxidant, a UV absorbent, a plasticizer can be added into the above-described photosensitive resin, if desired. Regardless of the location where the flat and smooth layer is contaminated, an appropriate resin or additives may be used for any of additives in order to improve a film-formation property, and to suppress generation of pinholes.

Smooth flatness of the flat and smooth layer is a value expressed by surface roughness specified by JIS B 0601, and preferably has a maximum cross-section height Rt(p) of 10 - 30 nm. When making Rt (p) to be 10 nm or more, coatability is not deteriorated even though a coating device is brought into contact with the surface of the flat and smooth layer in a coating system such as a wire bar, a wireless bar or the like at the stage where the after-mentioned silicon compound is coated. Further, when making Rt (p) to be 30 nm or more, asperity produced after coating the silicon compound can be smoothed.

### (Bleed-out protection layer)

Bleed-out protection layer is provided on the opposite surface of a substrate on which a flat and smooth layer is provided for the purpose of suppressing a phenomenon in which an unreacted oligomer and so forth is moved to the surface from the inside of a film support when heating a film in which the flat and smooth layer is provided, whereby the contact surface is to be contaminated. Basically, the breed-out protection layer may take the same structure as that of the flat and smooth layer, as long as this is serving as a function.

Examples of unsaturated organic compounds each having a polymerizable unsaturated group which is possible to be contained in the bleed-out protection layer include a polyvalent unsaturated organic compound having at least two polymerizable unsaturated groups in the molecule, a monovalent unsaturated organic compound having one polymerizable unsaturated group in the molecule, and so forth.

As other additives, a mat agent may be contained. As a mat agent, preferable are inorganic particles each having an average particle diameter of roughly 0.1- 5 µm. Examples of such an inorganic particles include silica, alumina, talc, clay, calcium carbonate, magnesium carbonate, barium sulfate, aluminum hydroxide, titanium dioxide, zirconium oxide and so forth, and these may be used singly, or in combination with at least two kinds thereof.

Herein, the mat agent composed of inorganic particles is desirably mixed to have a content of at least 2 parts by weight; preferably at least 4 parts by weight; and more preferably at least 6 parts by weight, but to have not more than 20 parts by weight; preferably not more than 18 parts by weight; and more preferably 16 parts by weight, based on 100 parts by weight of a hard coat agent in terms of a solid content.

Further, examples of other components for the hard coat agent and the mat agent contained in the flat and smooth layer of the present invention include a thermoplastic resin, a thermosetting resin, an ionizing radiation-curable resin, a photo-polymerization initiator and so forth.

After a hard coat agent, a mat agent, and another component, if desired are blended, and the resulting coating solution is coated on the surface of a support fihn by commonly known conventional coating method via preparation thereof as a coating solution employing a diluted solvent appropriately used if desired, the resulting system is exposed to ionizing radiation to form a bleed-out protection layer as described above.

In addition, an ionizing radiation exposure method can be conducted by delivering UV radiation having a wavelength range of 100 - 400 nm, and preferably a wavelength range of 200-400 nm emitted from an ultrahigh pressure mercury lamp, a high pressure mercury lamp, a low pressure mercury lamp, a carbon-arc lamp, a metal halide lamp or the like, or by delivering electron beam having a wavelength range of 100 nm or less emitted from a scanning type or curtain-type electron beam accelerator.

The bleed-out protection layer of the present invention preferably has a thickness of 1-10 µm, and more preferably has a thickness of 2 - 7 µm. In the case of a thickness of 1 µm or more, a film exhibits sufficient heat resistance, and in the case of a thickness of 10 µm or less, curling of a gas barrier film can be easily suppressed in cases where a flat and smooth layer is provided on one surface of a transparent polymer film, accompanied with making optical properties of the flat and smooth film to be easily balance-adjusted.

### (Application of gas barrier film)

The present invention is usable mainly for package of electronic devices and so forth, or for gas barrier films used for display material such as an organic EL element, a solar cell, and a plastic substrate provided for liquid crystal, and for resin substrates used for various devices each in which a gas barrier film is provided and various device elements.

The gas barrier film of the present invention is preferably usable as each of various sealing materials and films.

### (Organic photoelectric conversion element)

A gas barrier film of the present invention is usable for an organic photoelectric conversion element. Since a gas barrier film is transparent when using for the organic photoelectric conversion element, this gas barrier film can be designed to be used as a support so as to receive sunlight from this side.

That is, a transparent conductive thin film such as ITO or the like as a transparent electrode, for example, is provided on this gas barrier film to constitute a resin support used for an organic photoelectric conversion. Then, an ITO transparent conductive film provided on a support is used as an anode; a porous semiconductor layer is provided on this anode; and a cathode composed of a metal film is further formed to produce an organic photoelectric conversion element Another sealing material (the same material is also allowed to be used) is layered on this element, and the foregoing gas barrier film support adheres to circumference thereof to seal the element Thus, the organic photoelectric conversion element can be sealed. By doing this, the effects of moisture of outside air and gas such as oxygen or the like on the element can be suppressed.

A transparent conductive film is formed on a ceramic layer as a gas barrier film prepared in this way to obtain a resin support for the organic photoelectric conversion element A transparent conductive film can be formed by a vacuum evaporation method, a sputtering method or the like, and also prepared by a coating method such as a sol-gel method employing metal alkoxide of indium, tin or the like, and so forth.

The transparent conductive film is preferably a transparent conductive film having a film thickness of 0.1-1000 nm.

Next, each of organic photoelectric conversion element material layers (constituting layers) constituting an organic photoelectric conversion element will be described.

Preferred embodiments of organic photoelectric conversion elements of the present invention will be described, but are not limited to thereto. The organic photoelectric conversion element is not specifically limited, and may be an element of generating electric current via light-irradiation, in which an anode, a cathode, and at least one power generation layer (referred to also as a layer in which a p-type semiconductor and a n-type semiconductor are mixed; a bulk heterojunction; or an i layer) sandwiched between the anode and the cathode are provided.

Preferred specific examples of layer configuration for an organic photoelectric conversion element will be described below
(i) anode / power generation layer / cathode
(ii) anode / hole transport layer / power generation layer / cathode
(iii) anode / hole transport layer / power generation layer / electron transport layer / cathode
(iv) anode / hole transport layer / p-type semiconductor layer / power generation layer / n-type semiconductor layer / electron transport layer / cathode
(v) anode / hole transport layer / first power generation layer / electron transport layer / intermediate electrode / hole transport layer / second power generation layer / electron transport layer / cathode

Herein, a power generation layer should contain a p-type semiconductor material capable of transporting holes and an n-type semiconductor material capable of transporting electrons. These may be substantially two layers to produce heterojunction, or bulk heterojunction in the state where these are mixed in the inside of a single layer may be prepared, but the bulk heterojunction configuration is preferable since photoelectric conversion efficiency is high. The p-type semiconductor material and the n-type semiconductor material used for a power generation layer will be hereinafter described.

Since similarly to an organic EL element, taking-out efficiency of holes and electrons into anode cathode can be raised by sandwiching a power generation layer with a hole transport layer and an electron transport layer, configuration (ii) or (iii) having such a structure is preferable. Further, since a power generation layer itself enhances rectification of holes and electrons (selectivity to take carrier out), configuration (iv) in which a power generation layer is sandwiched by a layer formed only of a p-type semiconductor material and formed only of an n-type semiconductor material (referred to also as "p-i-n configuration") may be allowed to be used. Further, in order to raise sunlight-use efficiency, tandem configuration (v) in which sunlight having different wavelengths is absorbed by each of power generation layers may be also allowed to be used.

### (Embodiment)

Embodiments of the present invention will be described referring to Fig.1 to Fig. 5, but the present invention is not limited thereto.

Fig. 1 is a schematic diagram showing an example of an apparatus with which a gas barrier film is prepared by a slot-die coating method.

In the figure, when film 1 as a substrate is continuously conveyed with a wind-off apparatus, and passes through back-up roll 7, coating solution 6 containing polysilazane is coated on the film by slot-die 2 to form a coating film. When the film on which the coating film is formed passes through the subsequent drying zone 8, a solvent contained in the coating film is removed therefrom. Thereafter, the resulting one is exposed to vacuum UV radiation with vacuum UV radiation exposure apparatus 12. In this figure, back-up roll 11 is employed for the purpose of stably transporting the film during exposure to vacuum UV radiation, but the exposure to vacuum UV radiation is also possible to even though employing no back-up roll.

Since this figure shows a previously measured system coating method called a slot-die coating method, a coating solution is fed in a fixed quantity by pump 4. Pump 4 is connected to tank 5 in which the coating solution is stored, via a pipe, and further, it is conventionally done that the coating solution passes through filter 3 before the coating solution is fed to a slot-die thereof to remove foreign matter from the coating solution containing the foreign matter. In this case, the filter is formed from a filter material having an absolute filtration rating of a quasi- absolute filtration rating of 0.05 - 50 µm, and filtering is preferably done at least once.

Next, drying zone 8 will be described in detail.

Sealing devices 9 are placed both on the entrance side and on the exit side of drying zone 8 through which a support passes. The sealing device means a device provided in order to avoid outflow of atmospheric gas inside the drying zone and inflow of air in the atmosphere into the drying zone. The sealing device facing to each other are placed on the front and back of the support, and outlets of temperature-adjusted inert gas are provided. The outlets are arranged to be provided in the width direction of a coating film, and inert gas is evenly blown from slits, punch plates, a mesh or the like arranged to be placed in the width direction. Further, the inert gas flow can be adjusted with a valve or the like so as to adjust the blowing wind speed of the inert gas. Temperature is adjusted by making the inert gas to pass through a heat exchanger for steam, cold water, electricity and so forth. Further, filtering is done in order to dirt-remove foreign matter from the inert gas.

Drying of a coating film coated on a support starts immediately after coating the coating film on the support An apparatus with which a solvent evaporated at the coating section is supplied and evacuated should be provided. The drying zone is covered by a heat insulating panel, and has an approach port for a support to screen the coating section. Infrared rays or microwaves are often used for drying, but a device to evaporate the solvent from the coating section conventionally tends to be used by evenly blowing heated inert gas to the coating film. The drying zone in the form of a box is prepared in order to efficiently collect an evaporated solvent, or to control the drying environment. In this case, the drying zone may be composed of one drying zone, but the drying zone is separated into plural drying zones, and the drying condition of each drying zone can be selectively changed.

In the case of drying a coating film by blowing inert gas to the coating film, examples of the drying condition for each drying zone include drying temperature, blowing wind speed, distance between an inert gas outlet and a coating film, circulation flow of inert gas, concentration of a solvent inside the coating film and so forth, In addition to nozzles or slits 10 to blow inert gas to the coating film for supplying the inert gas into the drying zone, another supply opening which is difficult to have an influence on the coating caused by wind currents is often used in combination. In cases where a support is conveyed in the drying zone while supporting the support from the back surface of the support with supporting rolls, the supporting rolls each generally have a progress level of 100 µm or less, and preferably have a progress level of 50 µm or less.

The coating film up to the drying zone from the slot-die is not subjected to drying, and since foreign matter attached onto the surface adheres to the coating film, the surrounding cleaning degree should be maintained to be high. The cleaning degree inside the drying zone is class 1000 or less, and preferably is class 100 or less, depending on the character of manufacturing products.

The coating film is exposed to vacuum UV radiation emitted from vacuum UV radiation exposure apparatus 12 after or during passing through the drying zone, and is subsequently rolled up.

In addition, when the coating film until it enters the drying zone after conducting coating at the coating section is also designed to be in an oxygen atmosphere of 10% or less, or the coating film up to the VUV radiation exposure section from the exit of the drying zone or up to the area including the VUV radiation exposure section from the exit of the drying zone is also designed to be in an oxygen atmosphere of 10% or less, gas banier performance can be improved.

### EXAMPLE

Next, the present invention will be described in detail referring to Example, but the present invention is not limited thereto.

### <Example>

### [Support]

A polyester film (super-low heat shrinkage PET Q83, produced by Teijin Dupont Films Japan Ltd.) having a thickness of 125 µm, whose surfaces each are subjected to an easy adhesion treatment, as a thermoplastic resin support for a support.

### [Preparation of gas barrier film]

### [Formation of bleed-out protection layer]

After a UV curable organic / inorganic hybrid hard coat material OPSTAR Z7535 produced by JSR Corporation was coated on one surface of the above-described substrate by a slot-die so as to give a dry film thickness of 4 µm, curing was conducted under the air mode drying conditions of 80 °C and 3 minutes, the curing condition of 1.0 J/cm² under air atmosphere, and use of a high pressure mercury lamp to form a bleed-out protection layer.

### (Formation of flat and smooth layer)

Next, a UV curable organic / inorganic hybrid hard coat material OPSTAR Z7501 produced by JSR Corporation was coated on another surface of the above-described substrate by a slot die so as to give a dry film thickness of 4 µm, followed by drying under the drying conditions of 80 °C and 3 minutes, and curing was subsequently conducted under the curing conditions of 1.0 J/cm² under air atmosphere, and use of a high pressure mercury lamp to form a flat and smooth layer.

### [Formation of polysilazane layer]

Next, a polysilazane layer was coated on the flat and smooth layer surface of a support having the above-described flat and smooth layer and bleed-out protective layer provided on one side and another side of the support, respectively, by a manufacturing apparatus of a gas barrier film shown in Fig. 1, followed by drying to prepare sample No. 1. In addition, a dried sample was directly rolled up by a manufacturing apparatus of a gas barrier film of Fig. 1 excluding back-up roll 11 and vacuum UV radiation exposure apparatus 12.

Employing a dibutyl ether solution of 20% by weight (AQUAMICA NN120-20, produced by AZ electronic materials Co., Ltd.) as a perhydropolysilazane solution, this solution was diluted with dibutyl ether to adjust perhydropolysilazane (PHPS) concentration to 5% by weight; time consumed from right after coating to the exit of the drying zone was set to 3 minutes; and coating was conducted with a slot-die so as to give a dry film thickness of 170 nm to form a perhydropolysilazane-containing layer.

Sample Nos. 2-13 were prepared similarly to preparation of the above-described sample No. 1, except that the drying condition was replaced by those described in Table 1.

In addition, as to drying of sample No. 1, air obtained by heating air at a temperature of 25 °C and a humidity of 50%RH to 80 °C was used as supplying gas 20 supplied into the inside of a manufacturing apparatus of a gas barrier film, and as to drying of sample Nos. 2-13, supplying gas 20 was heated to 80°C and supplied in such a way that oxygen concentration of supplying gas 20 introduced into the inside of the apparatus was set to ± 0.1 % of the amount described in Table 1 by measuring nitrogen gas flow and oxygen gas flow with a flow meter.

### [VUV radiation exposure]

A square, 10 cm on a side was cut out of the above-described sample, and employing a stage-movable Xenon excimer exposure apparatus MODEL: MECL-M-1-200 (a wavelength of 172 nm) manufactured by M.D. Excimer Inc., the sample was reciprocation-transported at a stage-moving speed of 10 mm/sec while being maintained in such a way that exposure distance between a lamp and the above-described sample became 1 mm, and sample temperature became 75 °C. The sample was removed therefrom after it was exposed to VUV radiation during 5 round trips in total.

### [Adjusting oxygen concentration during exposure to VUV radiation]

As to oxygen concentration during exposure to VUV radiation, nitrogen gas flow and oxygen gas flow introduced into a VUV radiation exposure chamber were measured, and sample Nos. 1-6 were adjusted from a flow ratio of nitrogen gas to oxygen gas, introduced into the chamber so as to be within the range of an oxygen concentration of 1.0% ± 0.1%. Sample Nos 7-10 were adjusted so as to be within the range of an oxygen concentration of 0.5%±0.1%. Further, sample No.11 was adjusted so as to be within the range of an oxygen concentration of 1.5%±0.1%. Sample No.12 was adjusted so as to be within the range of an oxygen concentration of 0.03%±0.01%. Sample No. 13 was adjusted so as to be within the range of an oxygen concentration of 0.06%±00.1%.

Water vapor permeability was evaluated in order to evaluate gas barrier performance of these samples.

### [Water vapor permeability]

Evaluations were made by the following measuring method.

### (Apparatus)

Evaporator : Vacuum evaporator JEE-400 manufactured by JEOL Ltd.
Constant temperature and humidity oven: Yamato Humidic Chamber IG47M

### (Raw material)

Metal corroded via reaction with water: Calcium (in the form of particles)
Water vapor impermeable metal: Aluminum (in the form of particles each having a diameter of 3 - 5 mm)

### (Preparation of cell for water vapor barrier property)

A vacuum-evaporator JEE-400 manufactured by JEOL Ltd. was used, and portions other the portion of a barrier film sample (9 portions of square each, 12 mm on a side) each which was to be evaporated before providing a transparent conductive film were masked to evaporate metal calcium. The mask was subsequently removed therefrom in vacuum, and aluminum was evaporated on the entire surface on one side of a sheet from another metal evaporation source. After sealing with aluminum, a vacuum state was released; the aluminum-sealing side was opposed to quartz glass having a thickness of 0.2 mm via a UV curable resin (produced by Nagase ChemteX Corporation); and the resulting one was exposed to UV radiation to prepare a cell for evaluation.

The resulting sample in which both of the surfaces were sealed was stored at high temperature and high humidity, and a water content permeated inside a cell was calculated from a corrosion content of metal calcium in accordance with a method disclosed in Japanese Patent O.P.I. Publication No. 2005-283561.
5 : Less than 5 x 10⁻⁴g/m²/day
4 : Not less than 5 x 10⁻⁴g/m²/day and less than 5x 10⁻³g/m²/day
3 : Not less than 5 x 10⁻³g/m²/day and less than 5 x 10⁻²g/m²/day
2 : Not less than 5 x 10⁻² g/m²/day and less than 5 x 10⁻¹ g/m²/day
1 : Not less than 5 x 10⁻¹g/m²/day

### [Water vapor permeability aging stability]

The resulting gas barrier film was stored in a constant temperature and humidity oven having been adjusted to 85 °C, continuously for 7 days, and thereafter, water vapor permeability was evaluated by the same method and evaluation ranks as described before.

Constant temperature and humidity oven: Yamato Humidic Chamber IG47M

**Table 1**

| Sample No. | Drying step | Vacuum UV radiation exposure step | Evaluation | Remarks |
|---|---|---|---|---|
| | Concentration of oxygen (%) | Concentration of oxygen (%) | | |
| 1 | 21 | 1.0 | 1 | (Comparative example) |
| 2 | 10 | 1.0 | 2 | (Present invention) |
| 3 | 5 | 1.0 | 3 | (Present invention) |
| 4 | 3 | 1.0 | 3 | (Present invention) |
| 5 | 1 | 1.0 | 4 | (Present invention) |
| 6 | 0.5 | 1.0 | 4 | (Present invention) |
| 7 | 5 | 0.5 | 4 | (Present invention) |
| 8 | 3 | 0.5 | 4 | (Present invention) |
| 9 | 1 | 0.5 | 5 | (Present invention) |
| 10 | 0.5 | 0.5 | 5 | (Present invention) |
| 11 | 0.5 | 1.5 | 3 | (Present invention) |
| 12 | 0.5 | 0.03 | 3 | (Present invention) |
| 13 | 0.5 | 0.06 | 4 | (Present invention) |

According to the present invention, when the drying step was conducted at each oxygen concentration described in Table 1, and further, the vacuum UV radiation exposure step was conducted at each oxygen concentration described in Table 1, gas barrier films exhibiting excellent gas barrier performance were obtained.

### EXPLANATION OF NUMERALS

| | |
|---|---|
| 1 | Film |
| 2 | Slot-die |
| 3 | Filter |
| 4 | Pump |
| 5 | Tank |
| 6 | Coating solution |
| 7 | Back-up roll |
| 8 | Drying zone |
| 9 | Sealing device |
| 10 | Slit |
| 11 | Back-up roll |
| 12 | Vacuum UV radiation exposure apparatus |
| 13 | Wind-off roll |
| 14 | Roll-up roll |
| 20 | Supplying gas |
| 21 | Evacuating gas |

## Claims

1. A method of manufacturing a gas barrier film, comprising the steps of
coating a coating solution containing polysilazane on a surface of a film to form a coating film, followed by making the resulting film to pass through a drying zone, and
exposing the surface of the coating film to vacuum UV radiation to conduct a modification treatment,
wherein oxygen concentration in the drying zone, achieved by supplying inert gas into the drying zone is 10% or less.

2. The method of Claim 1,
wherein the oxygen concentration is 5% or less.

3. The method of Claim 1 or 2,
wherein the oxygen concentration during exposure to the vacuum UV radiation is 0.05-1%.

4. The method of any one of Claims 1 - 3,
wherein the vacuum UV radiation is emitted with a Xenon excimer lamp.
